# EUROPÄISCHE PATENTSCHRIFT

(11) **EP 0 592 938 B1**
(45) Veröffentlichungstag und Bekanntmachung des Hinweises auf die Patenterteilung: **23.07.1997**
(21) Anmeldenummer: 93116201.0
(22) Anmeldetag: 07.10.1993
(51) Int. Cl.: H05K 3/32, H01L 21/60, H01L 21/48

(54) **Verfahren zur Montage und Kontaktierung von elektronischen Bauelementen auf einem isolierenden Träger**
Process for mounting and contacting electronic components on an insulating support
Procédé pour le montage et la mise en contact de composants électroniques sur un support isolant

(30) Priorität: 16.10.1992 DE 4235019
(43) Veröffentlichungstag der Anmeldung: 20.04.1994
(73) Patentinhaber: LPKF CAD/CAM Systeme GmbH, D-30827 Garbsen/OT Berenbostel (DE)
(72) Erfinder: Deissner, Erich, Dipl.-Phys., D-58332 Schwelm (DE); de la Mothe Hood Hammond, Jonathan, Dipl.-Ing., D-42659 Solingen (DE); Meier, Dieter, Dr. Dipl.-Chem., D-58285 Gevelsberg (DE)
(74) Vertreter: Braun, Dieter, Dipl.-Ing. Patentanwälte Hagemann & Kehl

(56) Entgegenhaltungen:
- EP-A- 0 322 641
- DE-A- 2 835 015
- PATENT ABSTRACTS OF JAPAN, Bd. 015, Nr. 098 (E-1042)8. März 1991 & JP-A-02 307 292
- IBM TECHNICAL DISCLOSURE BULLETIN. Bd. 32, Nr. 12 , Mai 1990 , NEW YORK US Seiten 218 - 219 XP105334 'Direct lead attachment technology'
- PATENT ABSTRACTS OF JAPAN, Bd. 013, Nr. 254 (E-772)13. Juni 1989 & JP-A-01 051 693
- PATENT ABSTRACTS OF JAPAN, Bd. 016, Nr. 420 (E-1259)4. September 1992 & JP-A-04 144 143

## Beschreibung

Die Erfindung betrifft ein Verfahren zur Montage und Kontaktierung von mit Metallanschlüssen versehenen elektronischen Bauelementen auf einem isolierenden, mit Leiterbahnen zu versehenen Träger, wobei auf den Träger zunächst in Form einer Leiterbahnstruktur ein Katalysator für eine stromlose Metallabscheidung aufgetragen wird, die Bauelemente mit ihren Metallanschlüssen an vorbestimmten Stellen des Trägers positioniert werden und anschließend durch stromlose Metallabscheidung aus einem chemischen Metallisierungsbad die Kontaktierung der Metallanschlüsse gleichzeitig mit der Ausbildung der metallischen Leiterbahn auf der durch den Katalysatorauftrag definierten Leiterbahnstruktur vorgenommen wird.

Das Verfahren nach der Erfindung soll vornehmlich in der Anschluß- und Verbindungstechnik (ATV) bei der Halbleitertechnologie Anwendung finden, wenn elektrisch leitende Verbindungen von elektronischen Bauelementen, z. B. Si-Schaltkreisen, zur peripheren Umgebung oder untereinander herzustellen sind und wenn Bauelemente untereinander auch zugleich haftfest verbunden werden sollen.

Mit der schnellen Entwicklung der Mikroelektronik bezüglich komplexer Schaltungen mit mehr als 500.000 Transistoren und mit Taktraten über 100 MHz werden neue Wege der AVT erforderlich.

Der steigende Integrationsgrad, die hohen Übertragungsgeschwindigkeiten, niedrige Kapazitäten sowie ein ausgewogenes thermisches Verhalten, verbunden mit hoher Zuverlässigkeit, erfordern I/0-Belegungen von mehr als 500 und sind mit herkömmlichen Technologien der AVT ökonomisch nicht mehr lösbar.

Eine besondere Diskrepanz macht sich zwischen einerseits der Halbleiterentwicklung/Chip-Fertigung und andererseits der Gehäusetechnologie (Packaging) bemerkbar. Während bei der Halbleiterfertigung durch Reduzierung des Anschlußrastermaßes auf ≤ 1 Mikron problemlos Anschlußbelegungen > 500 erreicht sind, sind die derzeitigen Verbindungstechnologien, z. B. Bonden, Löten, begrenzt, und es gilt, neue Wege der AVT zu beschreiten und Probleme des Packaging zu lösen.

Eine bereits bekannte technische Lösung stellt dabei die MCM-Technologie (Multichip-Modul-Technologie) dar, bei der man zum jetzigen Zeitpunkt drei Kategorien von Multichipmodulen unterscheiden kann:
a) MCM/C-Technologie: Hier werden Keramiksubstrate bzw. ungesinterte Keramikfolien (green-tape) verwendet, die durch Laminierung von bis zu 30 Einzellagen einen Multichip/Multilayeraufbau garantieren.
   Mittlerweile wird auch niedrig-sinternde Keramik (ca. 850° C) verwendet, um mit den angebotenen Dickfilmpasten kompatibel zu sein.
b) MCM/D-Technologie: Als Basismaterialien werden Keramik, Metall und Silizium verwendet und ähnlich der Si-Waferproduktion abwechselnd leitende und isolierende Schichten aufgebracht.
c) MCM/L-Technologie: Diese Technologie geht von kunststoffgebundenen Isolationsmaterialien wie starren und flexiblen Leiterplatten aus und verwendet Feinstleiterstrukturen mit Folien- oder Lackbeschichtungen für Multilayeraufbauten.

Eine Standardtechnologie zur Mikroverbindungstechnik stellt weiterhin das TAB (Tape-Automated-Bonding) dar, bei dem die Aluminium-Kontaktoberflächen von IC-Chips mit erhöhten Kontakthöckern (Bumps) aus Gold versehen werden müssen. Die dazu notwendigen digitalgesteuerten Drahtbondmaschinen erfordern hohe Investitionskosten.

Ähnlich kostenungünstig ist die COB-Technologie (Chip on Board), die Mikroverbindungen ebenfalls über das Drahtbonden realisiert.

Ein weiterer technologisch aufwendiger Weg ist die Flip-Chip-Montage, bei der ohne Anwendung von Bonddrähten über aufgebrachte Kontakthöcker (Bumps) durch Mikrolötung der elektrische Kontakt geschlossen wird. Diese Technologie erfordert ausgewählte Materialkombinationen (Diffusionsbarrieren) an den Lötstellen und ist durch elektrochemische Potentialbildung bezüglich Klima- und Lebensdauerverhalten in der Zuverlässigkeit stark begrenzt.

In dem Vortrag von W. Schmidt, "A revolutionary answer to today's and future interconnect challanges", Vortrag auf der "Third European Joint Conference 17./18.06.1992", Brüssel, ist ausgeführt, mittels Polyimidfolien, bei denen durch Plasmaätzen gleichzeitig alle Durchbrüche (through-holes) in einem Arbeitsschritt erzeugt werden, die Packungsdichte und das Anschlußraster wesentlich zu erhöhen.

In der Literaturstelle Reichl, H., "Silizium Substrate für die AVT", Aufbau und Verbindungstechnik, Sonderdruck "Mikroperipherik", Oktober 1990, S. 17, wird dagegen versucht, Silizium als Trägermaterial für IC-Schaltkreise zu benutzen und durch "Anodic-Bonding" bei Temperaturen von 390 - 450° C Wafer haftfest und elektrisch leitend zu befestigen und zu kontaktieren.

In der Literaturstelle Jacobs, S.L.; Guthrie, W.E., "A new Multichip interconnect Technology", Proc. 1989 Int. Electron. Packaging Symp, S. 339 - 354, wird eine Multichip-Verbindungstechnologie dargestellt, die als Zwischenträger Glas verwendet und Polyimid als Isolator einsetzt, der durch Trockenätzen mit Löchern versehen werden kann. Die erzeugten Löcher (vias) werden anschließend mit Aluminium gefüllt, um so elektrisch leitende Verbindungen zum Chip zu schaffen.

Mit einer ähnlichen Technologie beschäftigen sich Casson, K.; Gibson, B.; Habeck, K., "Flip-on-flex: Soldered bumped IC's bond to NOVOCLAD - a new temperature, adhesiveless, flex material", Vortrag auf der "Third European Joint Conference 17./18.06,1992", Brüssel. Hier wird vorgeschlagen, die Bondpads auf dem Si-Chip, die üblicherweise für das Bonden mit Aluminium oder Gold beschichtet sind, mit lötfähigen Materialien zu beschichten und diese Chips (Bumptechnologien) mit z. B. flexiblen Materialien zu verbinden (Lötprozeß).

In der DE 40 04 068 A1 ist ein Verfahren zur Kontaktierung von elektronischen Bauelementen beschrieben, bei dem das elektronische Bauelement mit seinen Anschlüssen an den bereits ausgebildeten, zugeordneten Leiterbahnen des Trägers positioniert wird, wonach die Anschlüsse des elektronischen Bauelementes durch Ätzen freigelegt werden.
Anschließend erfolgt die Kontaktierung der Anschlüsse durch stromlose Metallabscheidung, wobei gleichzeitig Leiterverbindungen zu den Anschlüssen ausgebildet werden.

Die DE-OS 23 30 161 kennzeichnet den gegenwärtigen technologischen Stand der Verbindungstechnologie über zwei Ebenen mit Hilfe galvanischer Verfahren (Durchkontaktierung). Das elektronische Bauelement kann beispielsweise durch Flip-Chip-Montage elektrisch kontaktiert werden.

Durch die DE 39 32 017 A1 ist ferner bekannt, zur Herstellung von Leiterplatten eine katalytisch wirkende Siebdruckpaste zu verwenden, auf der Leiterbahnen durch stromlose Metallabscheidung aufgetragen werden können.

Alle genannten Technologien sind sehr komplex, schwer kontrollierbar, daher mit hohen Kosten verbunden und für neue Schaltkreisgenerationen, z.B. ASIC's, nur sehr begrenzt einsetzbar, insbesondere, wenn sich die Anschlüsse nicht nur an den Außenkanten der elektronischen Bauelemente befinden. So kann beispielsweise eine elektrische Kontaktierung von Anschlüssen, die über die gesamte Fläche verteilt sind (land arrays) nach der o.g. DE 40 04 068 A1 nicht mehr durchgeführt werden.

Deshalb müssen zukunftsweisende Verbindungstechnologien geschaffen werden, die kostengünstig die gestellten Anforderungen erfüllen.

Ein gattungsgemäßes Verfahren ist aus der Veröffentlichungen JP-A-1051693 und JP-A-2307292 her bekannt. Dort werden die Bauelemente mit ihren Metallanschlüssen auf der Leiterplatte positioniert. Durch stromlose Metallabscheidung werden Metallanschlüsse gleichzeitig mit der Ausbildung der metallischen Leiterbahn auf der Platte kontaktiert. Die Kontaktierung erfolgt dabei nur platteneinseitig.

Der Erfindung liegt die Aufgabe zugrunde, das bekannte, an sich bewährte Verfahren auch zur beidseitigen Kontaktierung von Bauelementen weiterzubilden.

Gelöst wird die Aufgabe durch die im Anspruch 1 angegebene Erfindung.

Anspruch 5 stellt eine vorteilhafte Anwendung des Verfahrens dar.

Die Unteransprüche stellen vorteilhafte Weiterbildungen der Erfindung dar.

Erfindungsgemäß ist vorgesehen, daß bei durch Löcher des Trägers hindurch zu kontaktierenden Bauelementen auch die Wandungen der Löcher zunächst mit dem Katalysator belegt werden, daß die Bauelemente mit ihren Anschlüssen auf den zugehörigen Löchern positioniert werden und daß anschließend die Kontaktierung der Anschlüsse gleichzeitig mit der Lochwandmetallisierung und der Ausbildung der metallischen Leiterbahnen erfolgt.

Bei beidseits zu bestückenden Trägern kann der Erfindung zufolge vorgesehen werden, daß der Träger zunächst beidseits mit dem Katalysator im Bereich der Leiterbahnstrukturen versehen und anschließend beidseits mit den Bauelementen bestückt wird und daß danach die Kontaktierung der Bauelemente und die Ausbildung der metallischen Leiterbahnen gleichzeitig durch die stromlose Metallabscheidung vorgenommen werden.

Das Verfahren nach der Erfindung zeichnet sich durch eine große Wirtschaftlichkeit und eine fast universelle Anwendbarkeit innerhalb der Anschluß- und Verbindungstechnik bei der Halbleitertechnologie aus. Es können in gleicher Weise aktive Bauelemente wie IC-s oder auch passive Bauelemente wie Widerstände oder Kondensatoren unter gleichzeitiger Ausbildung der Leiterbahnen kontaktiert werden. Von besonderem Vorteil ist dabei die hohe Haftfestigkeit der Metallabscheidungen am Träger und an den Bauelementen. Es können sowohl starre als auch flexible Träger verwendet werden.

Der Erfindung zufolge können für die stromlose Metallabscheidung Bäder verwendet werden, die jeweils eines der nachstehenden Metalle, bzw.

Metallkombinationen enthalten
chem. Nickel,
chem. Kupfer,
chem. Gold,
chem. Silber,
chem. Silber/Palladium,
chem. Zinn/Blei.
Bevorzugt wird das von der Firma Dermid, Waterbury, Connecticut, USA vertriebene "Stromlose Kupferbad" eingesetzt.

Die Herstellung von elektrischen Mikroverbindungen erfordert auf den elektronischen Bauelementen ein Metall, welches entsprechend seiner Stellung in der elektrochemischen Spannungsreihe eine stromlose Metallabscheidung ermöglicht, z. B. Nickel oder Gold. Galvanisch problematische Metalle (wie z. B. Aluminium o. ä.) müssen vorher mit galvanisch aktiven Metallen, z. B. durch ein geeignetes chemisches Bad, beschichtet werden.

Als Katalysator wird bei dem Verfahren nach der Erfindung vorteilhafterweise der von der Firma Bayer AG, Leverkusen, unter dem geschützten Warenzeichen "Bayprint" vertriebene Katalysator verwendet (Patent dazu EP 0 256 395B1, EP 0 322 641B1).

Das Verfahren nach der Erfindung wird im folgenden anhand der Zeichnung näher erläutert, in der zeigen:
- Fig. 1: einen mit elektronischen Bauelementen bestückten Träger,
- Fig. 2: die Montage und Kontaktierung eines Bauelementes mit einer auf der Oberseite des Trägers auszubildenden Leiterbahn und
- Fig. 3: die Montage und Kontaktierung eines Bauelementes mit einer auf der Unterseite des Trägers auszubildenden Leiterbahn.

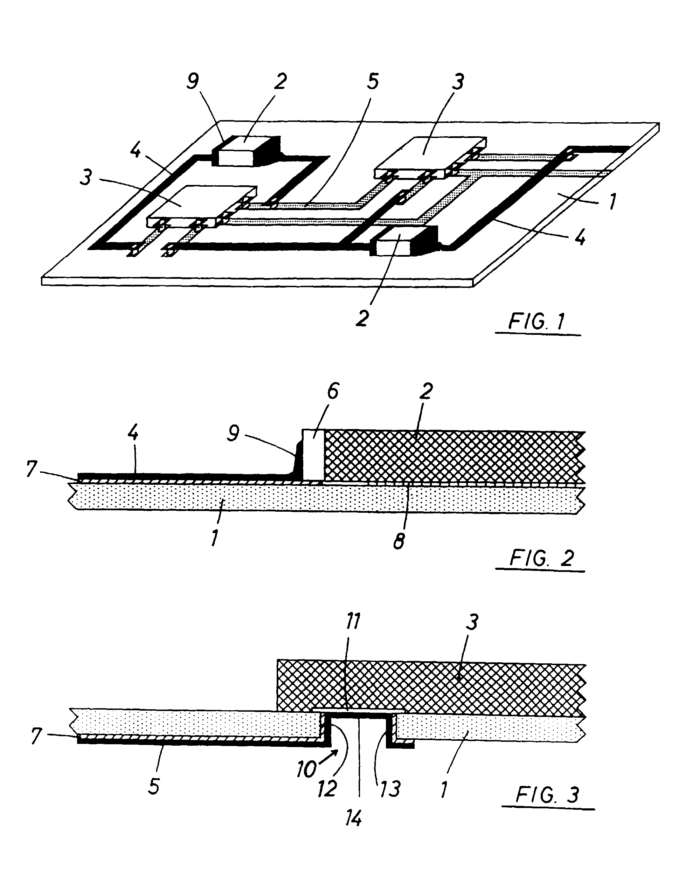

Fig. 1 zeigt einen Träger 1, bei dem es sich um eine starre Kunststoffplatte oder um eine flexible Kunststoffolie, z. B. aus Polyimid oder Polyester, handeln kann. Der Träger 1 ist auf seiner Oberseite mit elektronischen Bauelementen 2, 3 bestückt, die mit Leiterbahnen 4, 5 zu kontaktieren sind, die sich teils (in ausgezogenen Linien dargestellt) an der Oberseite des Trägers, teils (gepunktet dargestellt) an der Unterseite des Trägers befinden.

Fig. 2 veranschaulicht die Realisierung des Verfahrens nach der Erfindung bei der Kontaktierung eines Bauelementes 2 mit einer an der Oberseite des Trägers auszubildenden Leiterbahn 4. Als Beispiel ist hier ein gehäustes Bauelement SMD (surface mounted device) gezeigt, das randseitig mit Metallanschlüssen 6 versehen ist.

In einem ersten Arbeitsschritt wird auf der Oberseite des Trägers 1 ein Katalysator 7 entsprechend dem Leiterbahnmuster aufgetragen, was durch linienhaftes Bedrucken oder photochemische Behandlung eines vollflächig aufgetragenen Katalysators unter Verwendung einer Maske vorgenommen werden kann. Als Katalysatoren können z. B. die in der DE 39 32 017 A1 unter den Beispielen 1, 2 und 5 angegebenen Siebdruckpasten verwendet werden. Anschließend wird das Bauelement 2 auf dem Träger 1 positioniert und fixiert, z. B. mittels eines Klebers 8, wobei der Metallanschluß 6 auf die zugehörige, durch den Katalysator 7 vorbereitete "Leiterbahn" ausgerichtet wird.

In einem weiteren Arbeitsschritt wird der bestückte Träger 1 dann in ein chemisches Metallbad, z. B. ein formalinhaltiges Kupferbad, gebracht. Nach entsprechender Expositionszeit bei ausgewählten Badparametern, insbesondere Abscheidegeschwindigkeit, Redox-Potential, wird eine metallische, elektrisch leitende Kontaktierung 9 zwischen Metallanschluß 6 und der gleichzeitig durch Metallabscheidung sich bildenden metallischen Leiterbahn 4 geschaffen.

Fig. 3 veranschaulicht die Kontaktierung des Bauelementes 3 mit einer an der Unterseite des Trägers 1 auzubildenden Leiterbahn 5. Der Träger 1 ist mit Mikrolöchern 10 von z. B. 50 Mikron Durchmesser, z. B. durch Laserstrahlen, versehen. Beim Bauelement 3 handelt es sich hier um ein ungehäustes chip (flip-chip), das an seiner Unterseite eine Vielzahl von Anschlüssen 11 aufweist, bei denen es sich um sogenannte Anschlußflecken (pads) von einer Kantenlänge von 70 bis 100 Mikron handelt.

In einem ersten Arbeitsschritt wird auf der Unterseite des Trägers ein Katalysator 7 entsprechend dem Leiterbahnmuster aufgebracht. Der Katalysator 7 wird hierbei zugleich auf die Wandung 12 der Löcher 10 aufgetragen. Sodann wird das Bauelement 3 mit seinen Anschlußflecken 11 auf den Löchern 10 positioniert, so daß die durch den auch auf die Wandung 12 aufgetragenen Katalysator vorbereiteten "Leiterbahnen" bis zu den Anschlußflecken 11 reichen. Anschließend werden durch stromlose Metallabscheidung innerhalb eines Kupferbades die Leiterbahnen 5, die metallische Lochauskleidung 13 und die Kontaktierung 14 mit dem Anschlußflecken 11 ausgebildet. Die Schichtdicke der Metallabscheidung beträgt vorzugsweise 1 bis 3 Mikron.

Die Metallabscheidungen an der Leiterbahn 5, der Wandung des Loches 10 und an dem Anschlußflecken 11 besitzen eine große Haftfestigkeit, so daß in Anbetracht der in der Regel vielen hundert zu kontaktierenden Anschlußflecken 11 des Bauelementes 3 diese Metallabscheidungen ausreichen, um das Bauelement am Träger 1 dauerhaft zu fixieren. Statt einer Fixierung mittels eines Klebers genügt deshalb eine vorübergehende Fixierung, z. B. Anklammerung, des Bauelementes am Träger 1 während der stromlosen Metallabscheidung.

Wenn wie beim Ausführungsbeispiel nach Fig. 1 beide Trägerseiten bestückt und mit Leiterbahnen versehen werden sollen, wird zunächst beidseitig der Katalysator 7 aufgetragen, werden anschließend beidseits die Bauelemente 2 und 3 positioniert und nachfolgend die beschriebenen stromlosen Metallabscheidungen an beiden Seiten gleichzeitig vorgenommen.

### Bezugszeichenliste

- 1: Träger
- 2: Bauelement
- 3: Bauelement
- 4: Leiterbahn
- 5: Leiterbahn
- 6: Metallanschluß
- 7: Katalysator
- 8: Kleber
- 9: Kontaktierung
- 10: Mikroloch
- 11: Anschluß
- 12: Wandung
- 13: Lochauskleidung
- 14: Kontaktierung

## Patentansprüche

1. Verfahren zur Montage und Kontaktierung von mit Metallanschlüssen versehenen elektronischen Bauelementen auf einem isolierenden, mit Leiterbahnen zu versehenen Träger, wobei auf den Träger (1) zunächst in Form einer Leiterbahnstruktur ein Katalysator (7) für eine stromlose Metallabscheidung aufgetragen wird, die Bauelemente (3) mit ihren Metallanschlüssen (6) an vorbestimmten Stellen des Trägers (1) positioniert werden und anschließend durch stromlose Metallabscheidung aus einem chemischen Metallisierungsbad die Kontaktierung (10) der Metallanschlüsse (6) gleichzeitig mit der Ausbildung der metallischen Leiterbahn (5) auf der durch den Katalysatorauftrag definierten Leiterbahnstruktur vorgenommen wird,
dadurch gekennzeichnet,
daß der Katalysator (7) in Form einer Leiterbahnstruktur auf gegenüberliegenden Oberflächen des Trägers (1) aufgetragen wird und bei den durch Löcher (10) des Trägers (1) hindurch zu kontaktierenden Bauelementen (3) auch die Wandungen (12) der Löcher (10) zunächst mit dem Katalysator (7) belegt werden,
daß die Bauelemente (3) mit ihren Anschlüssen (11) auf den zugehörigen Löchern (10) positioniert werden und
daß bei der stromlosen Metallabscheidung eine Kontaktierung (14) der Anschlüsse (11) gleichzeitig mit der Metallisierung der Lochwandung (12) erfolgt.

2. Verfahren nach Anspruch 1, dadurch gekennzeichnet, daß der Träger (1) zunächst beidseits mit dem Katalysator (7) im Bereich der Leiterbahnstrukturen versehen, anschließend beidseits mit den Bauelementen (2, 3) bestückt wird und daß danach die Kontaktierung (9, 14) der Bauelemente (2, 3) und die Ausbildung der metallischen Leiterbahnen (4, 5) gleichzeitig durch die stromlose Metallabscheidung vorgenommen werden.

3. Verfahren nach den Ansprüchen 1 oder 2, dadurch gekennzeichnet, daß sowohl starre als auch flexible Träger (1) verwendet werden.

4. Verfahren nach einem der Ansprüche 1 bis 3, dadurch gekennzeichnet, daß für die stromlose Metallabscheidung Bäder verwendet werden, die jeweils eines der nachstehenden Metalle, bzw. Metallkombinationen, enthalten
chem. Nickel,
chem. Kupfer,
chem. Gold,
chem. Silber,
chem. Silber/Palladium,
chem. Zinn/Blei.

5. Verfahren zur Leiterplattenherstellung mit einem Montage- und Kontaktierungsverfahren nach einem der vorhergehenden Ansprüche.

## Claims

1. A process for mounting and bonding electronic components, provided with metal connections, on an insulating substrate to be provided with circuit tracks, whereby firstly a catalyst (7) for currentless metal deposition is applied onto the substrate (1), in the form of a circuit pattern, the components (3) are positioned with their metallic connections (6) in predetermined positions on the substrate (1), then, by currentless metal deposition from a chemical metallising bath, the formation of bonds (10) to the metal connections (6) is undertaken simultaneously with the formation of the metallic circuit tracks (5) onto the circuit pattern defined by the application of catalyst,
characterised in that,
the catalyst (7) is applied to opposite sides of the substrate (1) in the form of a circuit pattern and when the components (3) are to be bonded through holes (10) in the substrate (1) the walls (12) of the holes (10) are also first coated with catalyst (7),
that the components (3) are positioned with their connections (11) over the appropriate holes (10) and
that in the currentless metal deposition, bonding (14) of the connections (11) occurs at the same time as the metallising of the walls (12) of the holes.

2. A process according to Claim 1, characterised in that the substrate (1) is first provided with the catalyst (7) on both sides in the region of the circuit patterns, then the components (2, 3) are mounted on both sides with and that thereafter the bonds (9, 14) of the components (2, 3) and the formation of the metallic circuit tracks (4, 5) is undertaken simultaneously by currentless metal deposition.

3. A process according to Claim 1 or Claim 2, characterised in that both rigid and also flexible substrates (1) can be used.

4. A process according to any one of the Claims 1 to 3, characterised in that baths are used for the currentless metal deposition, which each contain one of the following metals or metal combinations
chemical Nickel,
chemical Copper,
chemical Gold,
chemical Silver,
chemical Silver/Palladium,
chemical Tin/Lead.

5. A process for circuit board manufacture with an assembly and bonding process according to one of the previous Claims.

## Revendications

1. Procédé de montage et de mise en contact de composants électroniques munis de connexions métalliques sur un substrat isolant devant être muni de pistes conductrices, un catalyseur (7) d'un dépôt de métal sans courant étant tout d'abord déposé sur le substrat (1) sous la forme d'une structure de pistes conductrices, les composants (3) étant positionnés de manière que leurs connexions métalliques (6) se trouvent en des emplacements prédéterminés du substrat (1) et ensuite la mise en contact (10) des connexions métalliques (6) s'effectuant simultanément avec la réalisation des pistes conductrices métalliques (5) sur la structure des pistes conductrices définie par le dépôt de catalyseur par dépôt sans courant de métal provenant d'un bain chimique de métallisation,
caractérisé
en ce que le catalyseur (7) est déposé sous la forme d'une structure de pistes conductrices sur les surfaces opposées du substrat (1) et les parois (12) des trous (10) sont aussi tout d'abord revêtues du catalyseur (7) pour les composants (3) devant être mis en contact par des trous (10) du substrat (1),
en ce que les connexions (11) des composants (3) sont positionnées sur les trous correspondants (10) et
lors du dépôt de métal sans courant, une mise en contact (14) des connexions (11) s'effectue simultanément avec la métallisation de la paroi (12) des trous.

2. Procédé selon la revendication 1, caractérisé en ce que le substrat (1) est muni tout d'abord des deux côtés du catalyseur (7) dans la zone des structures des pistes conductrices et ensuite il est équipé des deux côtés des composants (2, 3) et en ce que par la suite la mise en contact (9, 14) des composants (2, 3) et la réalisation des pistes conductrices métalliques (4, 5) s'effectuent simultanément par dépôt de métal sans courant.

3. Procédé selon les revendications 1 ou 2, caractérisé en ce que des substrats aussi bien rigides que souples (1) sont utilisés.

4. Procédé selon l'une des revendications 1 à 3, caractérisé en ce que les bains qui sont utilisés pour le dépôt de métal sans courant contiennent l'un des métaux suivants ou l'une des combinaisons suivantes de métaux
du nickel chimique,
du cuivre chimique,
de l'or chimique,
de l'argent chimique,
de l'argent/palladium chimique,
de l'étain/plomb chimique.

5. Procédé de réalisation de plaquettes de circuits imprimés par un procédé de montage et de mise en contact selon l'une des revendications précédentes.
